(19) Europäisches Patentamt
European Patent Office
Office européen des brevets

(11) Publication number: **0 062 679**
**B1**

(12) **EUROPEAN PATENT SPECIFICATION**

(45) Date of publication of patent specification: **11.09.85**

(51) Int. Cl.$^4$: **H 03 F 1/08,** H 03 F 3/343,
H 03 K 17/60

(21) Application number: **81902764.0**

(22) Date of filing: **09.10.81**

(86) International application number:
**PCT/JP81/00276**

(87) International publication number:
**WO 82/01449 29.04.82 Gazette 82/11**

# (54) TRANSISTOR AMPLIFIER CIRCUIT.

(30) Priority: **15.10.80 JP 143858/80**

(43) Date of publication of application:
**20.10.82 Bulletin 82/42**

(45) Publication of the grant of the patent:
**11.09.85 Bulletin 85/37**

(84) Designated Contracting States:
**DE FR GB**

(56) References cited:
**FR-A-1 465 815**
**JP-A-46 006 871**
**JP-A-50 061 165**
**JP-A-50 124 558**
**JP-U-54 028 350**
**US-A-3 725 754**

(73) Proprietor: **FANUC LTD**
**3580, Shibokusa Aza-Komanba Oshino-mura**
**Minamitsuru-gun Yamanashi 401-05 (JP)**

(72) Inventor: **KOBARI, Katsuo**
**17-35-210, Fujimi-cho 6-chome**
**Tachikawa-shi Tokyo 190 (JP)**
Inventor: **SAKAMOTO, Keiji**
**Room 405, Hino-shataku 27 Tamadaira 3-chome**
**Hino-shi Tokyo 191 (JP)**
Inventor: **KOBAYASHI, Toshio**
**Hino-ryo, 27 Tamadaira 3-chome**
**Hino-shi Tokyo 191 (JP)**

(74) Representative: **Billington, Lawrence Emlyn**
**et al**
**HASELTINE LAKE & CO Hazlitt House 28**
**Southampton Buildings Chancery Lane**
**London WC2A 1AT (GB)**

**EP 0 062 679 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**Description**

The present invention relates to a transistor amplifier circuit which comprises oscillation-opposing measures.

A transistor amplifier circuit designed for driving a transistor of relatively large input capacitance by another driving transistor may sometimes oscillate if the wire length between the transistors is large.

For example, in a power amplifier circuit for driving a servomotor, a Darlingtion transistor $TR_1$ constituted by a Darlington connection of an output stage transistor $Q_1$ and a driving stage transistor $Q_2$ is driven by another driving transistor $TR_2$ so as to obtain a high DC amplification factor, for instance, as shown in Fig. 1. In this case, the Darlington transistor $TR_1$ is usually packaged on a radiator because it calls for cooling, whereas the driving transistor $TR_2$ is packaged on a printed circuit board on the side of control equipment. Consequently, the wire length between the transistors $TR_1$ and $TR_2$ becomes large and, in some cases, resonance occurs between the inductance owing to this wire length, and the collector-base capacitance of the Darlington transistor $TR_1$, resulting in such oscillation as mentioned above. In Fig. 1, reference character PS indicates a driving power source, R a resistor, D a diode, $C_1$, $B_1$ and $E_1$ the collector, base and emitter of the Darlington transistor $TR_1$, and $C_2$, $B_2$ and $E_2$ the collector, base and emitter of the driving transistor $TR_2$.

The aforementioned oscillation could be prevented by the use of such a Darlington transistor which is constituted by a Darlington connection of three transistors on one chip as shown in an electric circuit diagram of Fig. 2, for instance; however, such a Darlington transistor is not manufactured for the reason that the switching time would be long.

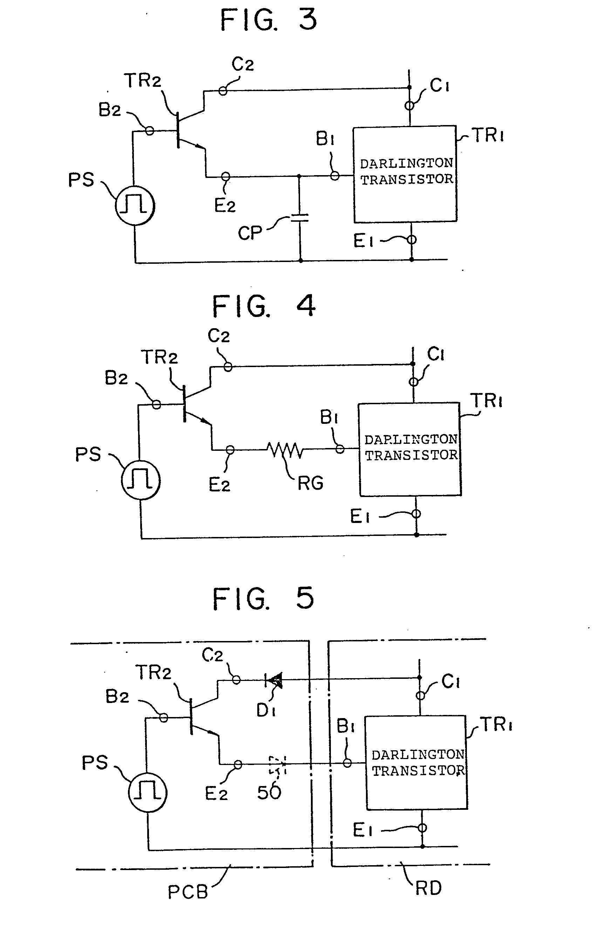

Heretofore, the oscillation has been prevented by connecting a capacitor CP of a suitable capacitance between the base and emitter of the Darlington transistor $TR_1$ as shown in an electric circuit diagram of Fig. 3 in which the Darlington transistor in Fig. 1 is indicated by a black box, or by connecting a resistor RG between the base $B_1$ of the Darlington transistor $TR_1$ and the emitter $E_2$ of the driving transistor $TR_2$ as shown in Fig. 4; however, the former method has the defect that a transistor of large current capacity is required as the driving transistor $TR_2$ because a current flows through the capacitor CP, and the latter method has the defect that a forward voltage drop of the Darlington transistor $TR_1$ becomes large, resulting in increased loss.

The present invention is intended to overcome such defects, and has for its object to prevent or reduce the aforementioned oscillation with a simple arrangement.

According to the present invention, there is provided a transistor amplifier circuit in which a transistor is connected to be driven by a driving transistor, the two transistors being interconnected via a diode which opposes oscillation in the circuit, characterised in that: the driven transistor has a relatively large input capacitance; an electrical connection between the two transistors is so long that if said diode were not provided oscillation would tend to occur between the inductance of said connection and the input capacitance of the driven transistor; and said diode is arranged and poled to conduct driving current which flows through the driving transistor to the driven transistor.

The rectifying operation of the oscillation-opposing diode inhibits the transmission and reception of current necessary for oscillation.

The current capacity value of the driving transistor need not be increased and loss does not increase, either.

For a better understanding of the invention and to show how it may be put into effect reference will now be made, by way of example, to the accompanying drawings in which:

Fig. 1 is an electrical circuit diagram showing a servo-motor driving power amplifier circuit;

Fig. 2 is an electrical circuit diagram of a Darlington transistor employing three transistors;

Figs. 3 and 4 are electrical circuit diagrams of conventional transistor amplifier circuits; and

Fig. 5 is an electrical circuit diagram illustrating the principal part of a circuit embodying the present invention;

Figs. 1 to 4 have already been described;

Fig. 5 is an electrical circuit diagram illustrating the principal part of an embodiment of the present invention. The parts corresponding to those in Fig. 1 are identifed by the same reference characters. Reference character $D_1$ indicates a diode for preventing oscillation, PCB a printed circuit board, and RD a radiator.

According to this embodiment, as shown in Fig. 5, in a power amplifier circuit in which the Darlington transistor $TR_1$ is packaged on the radiator RD for cooling it and the driving transistor $TR_2$ therefor is packaged on the printed circuit board PCB on the side of the control equipment, the oscillation preventive diode $D_1$ of a polarity shown is connected between the collector $C_1$ of the Darlington transistor $TR_1$ and the collector $C_2$ of the driving transistor $TR_2$.

With such an arrangement, in a closed loop

$$C_1 \rightarrow D_1 \rightarrow C_2 \rightarrow E_2 \rightarrow B_1 \rightarrow C_1,$$

current flows only in the forward direction of the oscillation preventive diode $D_1$. Consequently, transmission and reception of current necessary for oscillation cannot be effected between the collector-base capacitance of the Darlington transistor $TR_1$ and the inductance of the wire length between the radiator RD and the printed circuit board PCB, thus ensuring that oscillation is prevented.

As will be appreciated from the principle of the present invention, it is sufficient if the oscillation preventive diode $D_1$ is connected at least either between the collectors of the Darlington

transistor $TR_1$ and the driving transistor $TR_2$, or between the base $B_1$ of the Darlington transistor $TR_1$ and the emitter $E_2$ of the driving transistor $TR_2$, as indicated by the broken line 50 in Fig. 5. Its packaging is carried out on the printed circuit board PCB in practice. However, sometimes a circuit for increasing the switching speed of the Darlington transistor $TR_1$ is connected between the base $B_1$ of the Darlington transistor $TR_1$ and the emitter $E_2$ of the driving transistor $TR_2$ and, in such a case, it may be difficult or improper to connect the oscillation preventative diode $D_1$ at the position 50; in this case, the oscillation preventive diode $D_1$ is connected between the collectors of the Darlington transistor $TR_1$ and the driving transistor $TR_2$.

While in the foregoing embodiment the present invention has been described as being applied to a transistor amplifier circuit arranged to drive a Darlington transistor by another transistor, the invention is not limited specifically thereto but may also be applied to a transistor amplifier circuit which drives an individual transistor of relatively large input capacitance by another transistor and is liable to oscillate due to large wire length between the two transistors. The same effect as mentioned previously can be obtained.

The present invention has the advantage that oscillation can be prevented with an extremely simple arrangement, without the necessity of increasing the current capacity value of the driving transistor as in the case of the prior art circuit shown in Fig. 3 and without incurring an increase in loss as in the conventional circuit depicted in Fig. 4. Accordingly, the present invention, when applied to a servomotor driving power amplifier or the like, enhances its reliability, and hence is of great utility.

## Claims

1. A transistor amplifier circuit in which a transistor ($TR_1$) is connected to be driven by a driving transistor ($TR_2$), the two transistors ($TR_1$, $TR_2$) being interconnected via a diode ($D_1$) which opposes oscillation in the circuit, characterised in that: the driven transistor ($TR_1$) has a relatively large input capacitance; an electrical connection between the two transistors ($TR_1$, $TR_2$) is so long that if said diode ($D_1$) were not provided oscillation would tend to occur between the inductance of said connection and the input capacitance of the driven transistor ($TR_1$); and said diode ($D_1$) is arranged and poled to conduct driving current which flows through the driving transistor ($TR_2$) to the driven transistor ($TR_1$).

2. A transistor amplifier circuit according to claim 1, characterised in that the driven transistor ($TR_1$) is a Darlington transistor.

3. A transistor amplifier circuit according to claim 1 or 2, characterised in that the driven transistor ($TR_1$) is packaged on a radiator (RD) for cooling purposes.

4. A transistor amplifier circuit according to any preceding claim, characterised in that the driving transistor ($TR_2$) is packaged on a printed circuit board.

5. A transistor amplifier circuit according to any preceding claim, characterised in that the diode ($D_1$) interconnects the collectors of the two transistors ($TR_1$, $TR_2$) and is poled in the direction from the collector of the driven transistor ($TR_1$) to the collector of the driving transistor ($TR_2$).

6. A transistor amplifier circuit according to any of claims 1 to 4, characterised in that the diode ($D_1$) connects the emitter of the driving transistor ($TR_2$) to the base of the driven transistor ($TR_1$) and is poled in that same direction.

## Revendications

1. Un circuit amplificateur à transistor dans lequel un transistor ($TR_1$) est connecté de façon à être attaqué par un transistor d'attaque ($TR_2$), les deux transistors ($TR_1$, $TR_2$) étant interconnectés par l'intermédiaire d'une diode ($D_1$) qui s'oppose à une oscillation dans le circuit, caractérisé en ce que: le transistor d'attaque ($TR_1$) a une capacité d'entrée relativement élevée; une connexion électrique entre les deux transistors ($TR_1$, $TR_2$) est tellement longue que si la diode ($D_1$) n'était pas incorporée, une oscillation tendrait à apparaître entre l'inductance de ladite connexion et la capacité d'entrée du transistor attaqué ($TR_1$); et le branchement et la polarité de la diode ($D_1$) sont tels que cette diode conduit un courant d'attaque qui traverse le transistor d'attaque ($TR_2$) en direction du transistor attaqué ($TR_1$).

2. Un circuit amplificateur à transistors selon la revendication 1, caractérisé en ce que le transistor attaqué ($TR_1$) est une transistor Darlington.

3. Un circuit amplificateur à transistors selon la revendication 1 ou 2, caractérisé en ce que le transistor d'attaque ($TR_1$) est monté sur un radiateur (RD) pour assurer le refroidissement.

4. Un circuit amplificateur à transistors selon l'une quelconque des revendications précédentes, caractérisé en ce que le transistor d'attaque ($TR_2$) est monté sur une carte de circuit imprimé.

5. Un circuit amplificateur à transistors selon l'une quelconque des revendications précédentes, caractérisé en ce que la diode ($D_1$) interconnecte les collecteurs des deux transistors ($TR_1$, $TR_2$) et est branchée avec une polarité telle qu'elle conduit dans la direction allant du collecteur du transistor attaqué ($TR_1$) vers le collecteur du transistor d'attaque ($TR_2$).

6. Un circuit amplificateur à transistors selon l'une quelconque des revendications 1 à 4, caractérisé en ce que la diode ($D_1$) est connectée de l'émetteur du transistor d'attaque ($TR_2$) vers la base du transistor attaqué ($TR_1$), et sa polarité correspond à la conduction dans cette même direction.

## Patentansprüche

1. Transistorverstärkerschaltung, bei der ein

Transistor ($TR_1$) derart angeordnet ist, daß er durch einen treibenden Transistor ($TR_2$) gesteuert wird, wobei die beiden Transistoren ($TR_1$, $TR_2$) über eine Diode ($D_1$), die Schwingungen in der Schaltung verhindert, miteinander verbunden sind, dadurch gekennzeichnet, daß der getriebene Transistor ($TR_1$) eine verhältnismäßig große Eingangskapazität hat, daß eine elektrische Verbindung zwischen den beiden Transistoren ($TR_1$, $TR_2$) so lang ausgebildet ist, daß wenn die Diode ($D_1$) nicht vorgesehen wäre, Schwingungen zwischen der Induktanz der Verbindung und der Eingangskapazität des getriebenen Transistors ($TR_1$) auftreten würden, und daß die Diode ($D_1$) derart angeordnet und gepolt ist, daß sie für einen Treiberstrom leitend ist, der durch den treibenden Transistor ($TR_2$) zu dem getriebenen Transistor ($TR_1$) fließt.

2. Transistorverstärkerschaltung nach Anspruch 1, dadurch gekennzeichnet, daß der getriebene Transistor ($TR_1$) ein Darlington-Transistor ist.

3. Transistorverstärkerschaltung nach Anspruch 1 oder 2, dadurch gekennzeichnet, daß der getriebene Transistor ($TR_1$) zu Kühlungszwecken auf einem Kühlkörper (RD) angeordnet ist.

4. Transistorverstärkerschaltung nach einem der vorhergehenden Ansprüche, dadurch gekennzeichnet, daß der treibende Transistor ($TR_2$) auf einer gedruckten Schaltungsplatee angeordnet ist.

5. Transistorverstärkerschaltung nach einem der vorhergehenden Ansprüche, dadurch gekennzeichnet, daß die Diode ($D_1$) die Kollektoren der beiden Transistoren ($TR_1$, $TR_2$) miteinander verbindet und für einen Stromfluß in der Richtung von dem Kollektor des getriebenen Transistors ($TR_1$) zu dem Kollektor des treibenden Transistors ($TR_2$) gepolt ist.

6. Transistorverstärkerschaltung nach einem der Ansprüche 1 bis 4, dadurch gekennzeichnet, daß die Diode ($D_1$) den Emitter des treibenden Transistors ($TR_2$) mit der Basis des getriebenen Transistors ($TR_1$) verbindet und in derselben Richtung wie diese gepolt ist.

FIG. 1

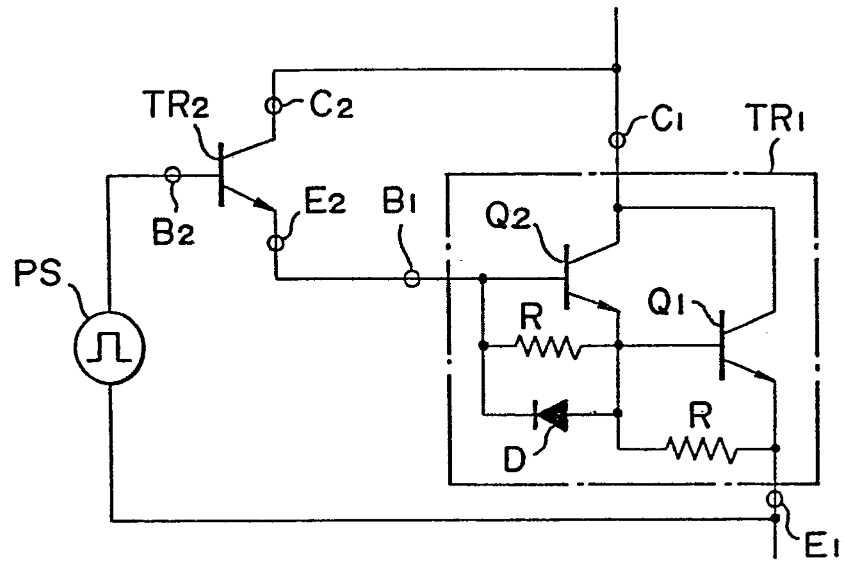


FIG. 2

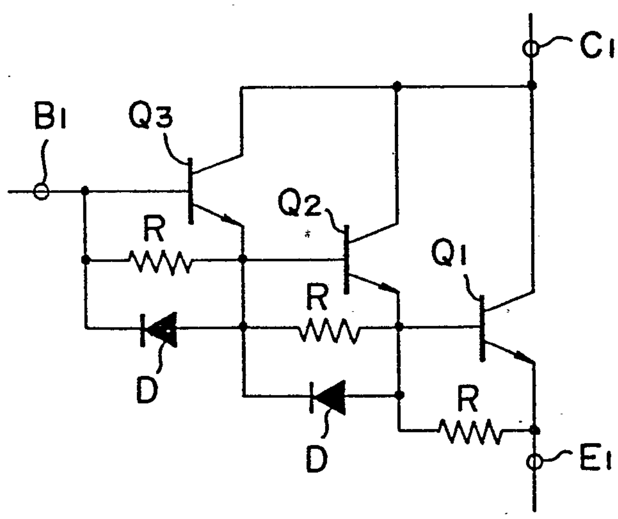

FIG. 3

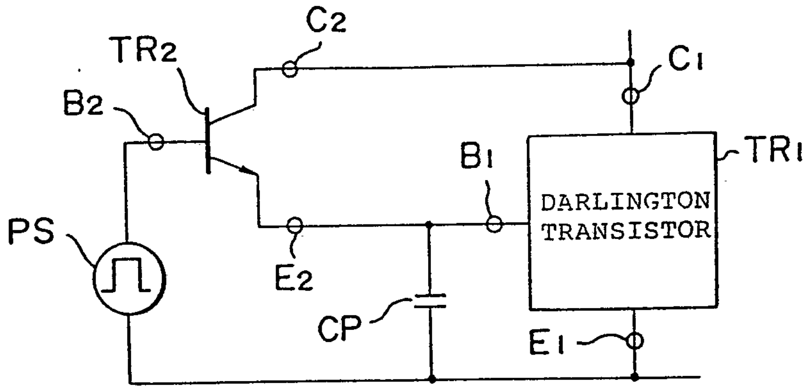


FIG. 4

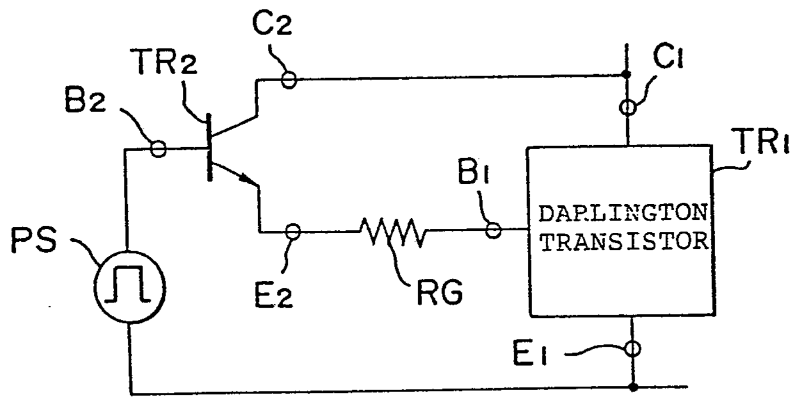


FIG. 5